(19) Europäisches Patentamt
European Patent Office
Office européen des brevets

(11) **EP 1 498 739 B1**

(12) **FASCICULE DE BREVET EUROPEEN**

(45) Date de publication et mention
de la délivrance du brevet:
**05.04.2006 Bulletin 2006/14**

(51) Int Cl.:
***G01R 15/20*** *(2006.01)*

(21) Numéro de dépôt: **03015934.7**

(22) Date de dépôt: **12.07.2003**

(54) **Capteur de courant électrique ayant un noyau magnétique avec entrefer et circuit d'alimentation de puissance muni de tels capteurs**

Stromsensor mit einem einen Luftspalt aufweisenden Magnetkern und damit ausgerüstete Energieversorgungsschaltung

Current sensor having a magnetic core with airgap and power supply circuit provided with such sensors

(84) Etats contractants désignés:
**AT BE BG CH CY CZ DE DK EE ES FI FR GB GR HU IE IT LI LU MC NL PT RO SE SI SK TR**

(43) Date de publication de la demande:
**19.01.2005 Bulletin 2005/03**

(73) Titulaire: **LIAISONS ELECTRONIQUES-MECANIQUES LEM S.A.**
**1228 Plan-les-Ouates (CH)**

(72) Inventeurs:
• **Cattaneo, Pierre**
**74160 Collonges-sous-Salève (FR)**
• **Gudel, Claude**
**74100 Le Pas de L'Echelle (FR)**

(74) Mandataire: **Reuteler, Raymond Werner**
**WILLIAM BLANC & CIE,**
**Conseils en Propriété Industrielle SA,**
**25, Avenue du Pailly**
**1220 Les Avanchets/Genève (CH)**

(56) Documents cités:
**EP-A- 0 578 948          DE-A- 10 028 448**
**FR-A- 2 594 551**

• **OGASAWARA S ET AL: "A digital current sensor for PWM inverters" PROCEEDINGS OF THE INDUSTRY APPLICATIONS SOCIETY ANNUAL MEETING. HOUSTON, OCT. 4 - 9, 1992, NEW YORK, IEEE, US, vol. 1, 4 octobre 1992 (1992-10-04), pages 949-955, XP010063656 ISBN: 0-7803-0635-X**

**Description**

La présente invention concerne un capteur de courant à boucle ouverte, notamment un capteur de courant pour la mesure de courant dans des circuits de puissance ou d'alimentation de moteurs électriques, ainsi qu'un circuit d'alimentation muni de tels capteurs.

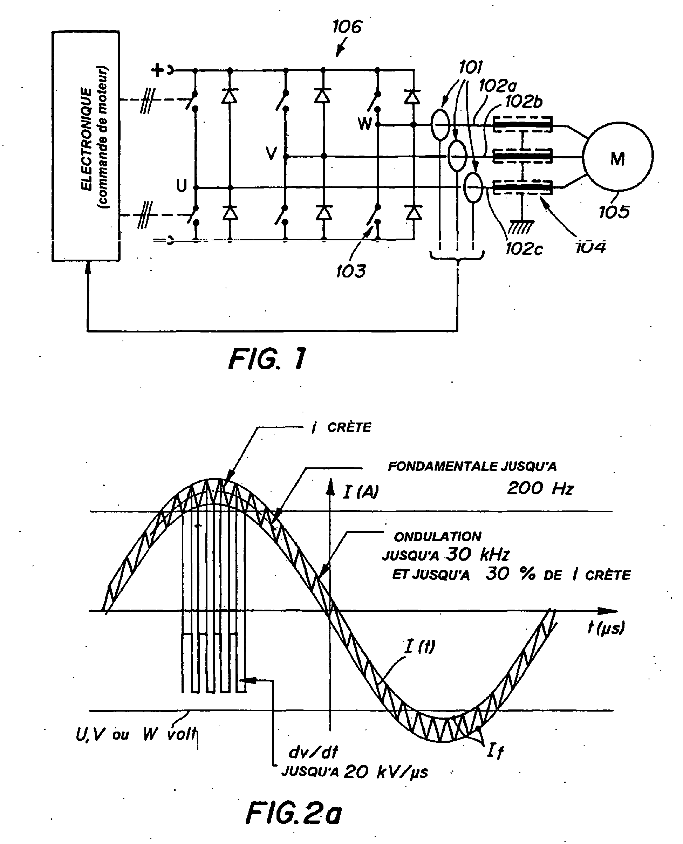

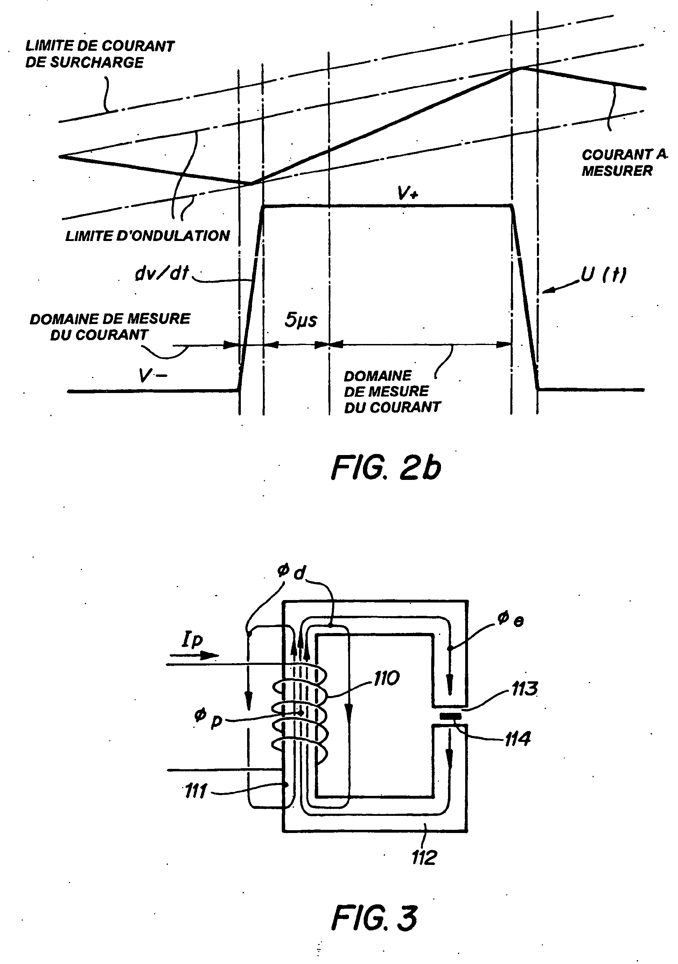

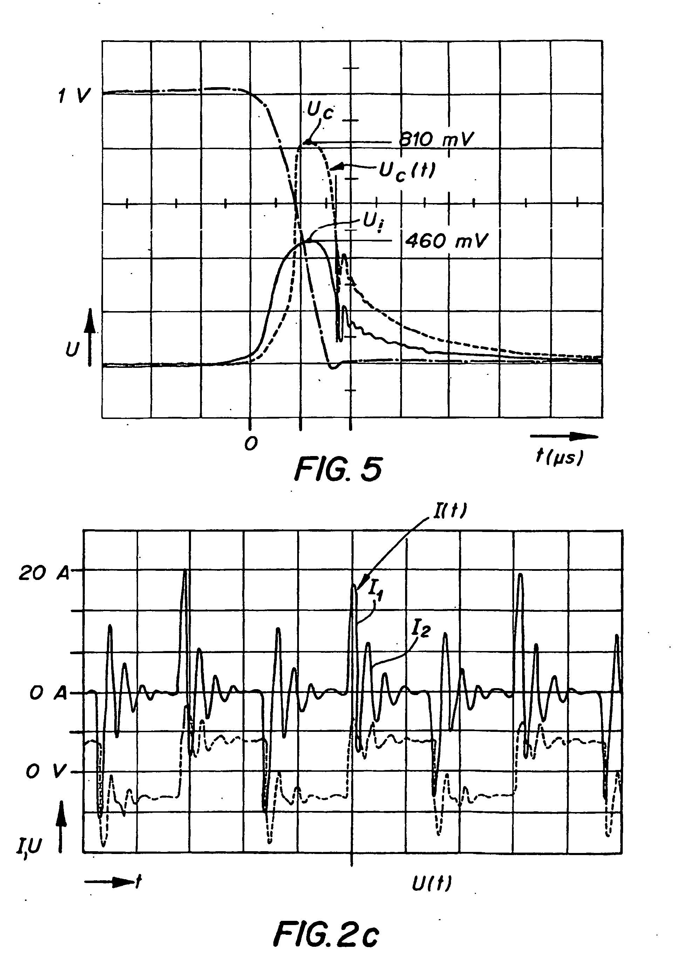

Dans les circuits d'alimentation 106 modernes, tel que montré dans la figure 1, le courant d'alimentation du moteur 105 est généré par des commutateurs semi-conducteurs 103 commutées à fréquence élevée. Le courant I(t) effectivement généré a typiquement une fréquence de quelques dizaines de kHz, alors que la fréquence fondamentale $I_f$ du courant d'alimentation, ayant une forme générale sinusoïdale représentée par l'enveloppe du courant I(t), est relativement faible, par exemple de l'ordre de quelques centaines de Hz, tel que illustré dans la figure 2a. Les avancées technologiques réalisées dans la conception de semi-conducteurs de puissance permettent aux commutateurs 103 des vitesses de commutation extrêmement élevées, la vitesse de variation de potentiel dV/dt étant par exemple de l'ordre de 10 à 20 kV/μs, tel que illustré dans la figure 2b. Afin de contenir le rayonnement électrique provoqué par de telles vitesses de variation de potentiel, on emploi des câbles coaxiaux 104 pour l'alimentation du moteur 105. Puisque ces câbles sont fortement capacitifs, et compte tenu du dv/dt appliqué, des courants hautes fréquences (HF) parasites sont générés sous la forme d'oscillations amorties à chaque commutation. L'amplitude et la fréquence de ces courants sont du même ordre de grandeur quelque soit la puissance de l'entraînement. En effet, ils ne dépendent pratiquement que des caractéristiques des câbles coaxiaux utilisés et de l'amplitude des dV/dt appliqués. L'amplitude de ces courants peut atteindre plusieurs dizaines d'Ampères et leurs fréquences s'échelonnent de 100 kHz à 1 MHz.

Les capteurs de courant 101 sont généralement placés sur des lignes 102a, 102b, 102c d'alimentation du moteur 105. Bien que ces courants HF ne soient pas à mesurer, ils traversent néanmoins les capteurs de courant. Dans les entraînements 106 de petite et moyenne puissance, l'amplitude de ces courants parasites peut être beaucoup plus élevée que celles des courants nécessaires au contrôle du moteur. La figure 2c montre, sur un écran d'oscilloscope, la tension U(t) et le courant I(t) haute fréquence dus aux commutations et aux charges capacitives sur une phase d'un moteur 5.5kW alimenté par un circuit d'alimentation commuté à 16kHz. Dans cet exemple, l'amplitude des première et deuxième demi-alternances $I_1, I_2$ est d'environ 20A et 8A respectivement. En pratique une amplitude aux premières demi-alternances $I_1$ et $I_2$ de 20A à 30A crête est courante.

Les inventeurs ont réalisé que ceci apporte deux principaux problèmes. Le premier est une augmentation du courant thermique traversant le capteur qui peut se résoudre en dimensionnant le capteur en fonction de la somme des courants rms qui le traversent. Un autre problème est un échauffement très important au circuit magnétique dû aux pertes par hystérésis et aux pertes par courants de Foucault.

Il convient de souligner que ces problèmes ne se retrouvent pas dans les capteurs type "boucle fermée" car, aux erreurs de compensation près, les ampères-tours (At) primaires sont compensés par les ampères-tours secondaires.

Il est à remarquer que l'échauffement du circuit magnétique sera d'autant plus élevé, et donc gênant, que le calibre du capteur est petit. Ceci est dû aux contraintes de dimensionnement des petits capteurs de courant boucle ouverte. En effet, pour des raisons de précision de mesure, il n'est pas approprié de concevoir un capteur en dessous d'un niveau minimum de 40 ampères-tours. Ceci signifie qu'un capteur de calibre nominal 10A sera conçu avec 4 spires primaires tandis qu'un capteur de 40A nominal pourra être conçu avec simplement 1 spire primaire. Ainsi, dans le premier cas, l'amplitude des courants HF et l'induction magnétique résultante seront multipliées par 4 par rapport au second cas et en conséquence, l'échauffement dû aux pertes par hystérésis et aux pertes dynamiques seront 16 fois plus élevées, comme on en peut déduire de la relation suivante:

$$\text{Pertes}_{(w)} \approx f^2 B^2 d^2 / \varphi$$

où d est l'épaisseur des tôles magnétiques, B est l'induction magnétique, f est la fréquence de l'induction et donc du courant parasite HF et $\varphi$ est la résistivité de l'alliage ferromagnétique constituant le circuit magnétique du capteur.

Les essais montrent que des températures de 200° C à 300° C, voire plus, seraient atteintes avec les capteurs boucle ouverte de petit calibre et de construction traditionnelle si on les utilisait tels quels dans les applications décrites ci-dessus.

En pratique, ce type de capteur ne peut être utilisé que si l'on dispose sur ses connections primaires un circuit annexe qui dérive les courants H.F.; cependant, ce circuit présente l'inconvénient de détruire les performances dynamiques du capteur et grève ainsi le rendement de l'entraînement. Pour ces raisons, ce type de capteur n'est pas, jusqu'à présent, employé dans les entraînements de moteurs performants; il est remplacé par un capteur du type "boucle fermée" plus coûteux.

En outre, EP 0 578 948 A1 et DE 100 28 448 décrivent des capteurs de courant.

Au vu de ce qui précède, un but de l'invention est de réaliser un capteur de courant à boucle ouverte ayant les performances dynamiques requises et qui peut supporter des courants élevés circulant dans le conducteur primaire. Un autre but de l'invention est de fournir un circuit d'alimentation de puissance muni de tels capteurs.

Il est avantageux de réaliser un capteur de courant boucle ouverte pouvant supporter des courants HF parasites générés par des vitesses de variation de potentiel (dV/dt) élevées, tels que présent dans des circuits de commutation à semi-conducteur pour l'alimentation de moteurs électriques.

Il est avantageux de réaliser un capteur à boucle ouverte compact et peu coûteux.

Des buts de l'invention sont réalisés par un capteur à boucle ouverte selon la revendication 1 et un circuit d'alimentation de puissance selon la revendication 5.

Le capteur de courant à boucle ouverte comprend un circuit magnétique ayant un entrefer, un détecteur de champ magnétique disposé dans l'entrefer, et un conducteur primaire, dans lequel le courant à mesurer circule, ayant un ou plusieurs spires entourant le circuit magnétique. Le capteur de courant à boucle ouverte est caractérisé en ce que les spires du conducteur primaire sont disposées à proximité de l'entrefer, de part et d'autre de l'entrefer. Dans cette partie du circuit magnétique, la perméabilité locale est beaucoup plus faible que dans toutes les autres parties du circuit magnétique à cause de la présence de l'entrefer ($\mu_{air}$ = 1). Vu des spires primaires, la perméabilité effective du circuit magnétique est beaucoup plus faible. De ce fait, pour la même valeur d'ampères-tours primaires, l'induction magnétique dans le noyau magnétique (aussi appelé « le fer ») est localement, mais aussi globalement, plus faible. Par conséquence, les pertes par hystérésis et par courants de Foucault sont minimisées.

D'autres buts et aspects avantageux de l'invention ressortiront de la description, des revendications et des dessins annexés, dans lesquels:

La Fig. 1 est une vue schématique d'un circuit d'alimentation de courant électrique d'un moteur électrique;

La Fig. 2a est une représentation graphique du courant et du potentiel généré par le circuit d'alimentation sur une phase connectée au moteur;

La Fig. 2b est une représentation en détail (agrandie) du courant et du potentiel généré par le circuit d'alimentation sur une phase connectée au moteur;

La Fig. 2c est une vue d'un écran d'oscilloscope montrant la tension en sortie de phase et courant haute fréquence dus aux commutations et aux charges capacitives sur une phase;

La Fig. 3 est une vue simplifiée d'un capteur de courant à boucle ouverte conventionnel montrant les lignes de flux magnétique;

La Fig. 4a est une vue en perspective d'un capteur de courant à boucle ouverte selon l'invention;

La Fig. 4b est une vue en perspective d'une variante d'un capteur de courant à boucle ouverte selon l'invention;

La Fig. 4c est une vue en perspective d'une variante d'un capteur de courant à boucle ouverte selon l'invention;

La Fig. 5 est un graphique montrant la surtension V = L dI/dt aux bornes du primaire d'un capteur conventionnel, et respectivement d'un capteur selon l'invention;

Les Figures 6a et 6b sont des graphiques montrant l'évolution de la température dans le circuit magnétique d'un capteur conventionnel, respectivement d'un capteur selon l'invention sur une ligne alimentée par un courant sinusoïdal ayant une fréquence de 200 KHz-

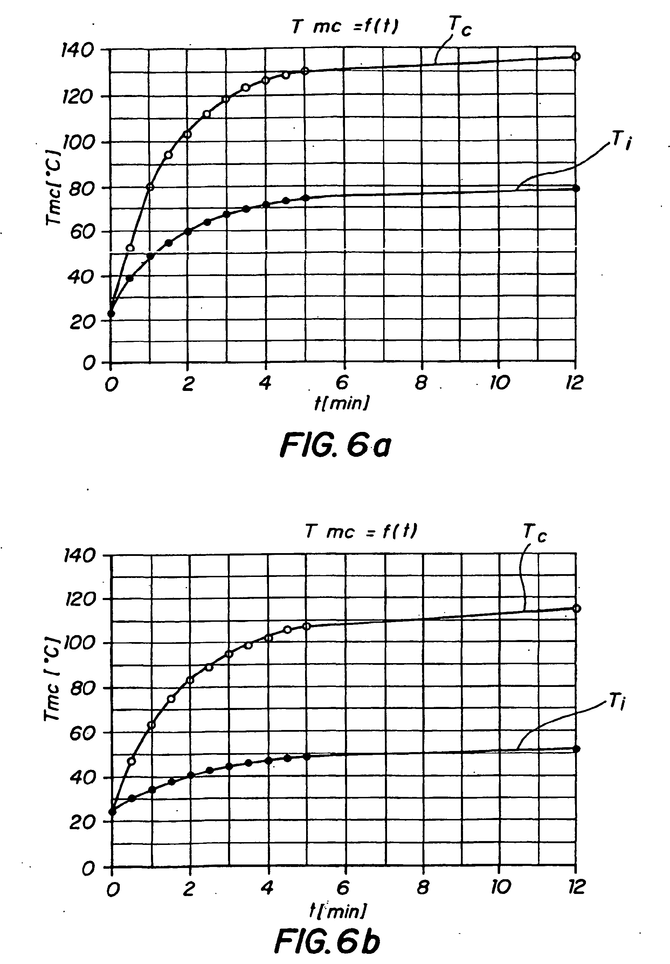

- La Fig. 6a concerne un capteur avec: huit spires primaires parcourues par un courant de 5 A, soit 40At; un circuit magnétique en fer-silicium ayant un entrefer de 1.3 mm de longueur et constitué d'un empilement de huit tôles de 0,35 mm d'épaisseur; sa section est de 9,8 mm$^2$ et sa longueur moyenne mesure 40 mm;

- La Fig. 6b concerne un capteur avec: douze spires primaires parcourues par un courant de 3.33 A, soit 40 At; un circuit magnétique en fer-nickel, ayant un entrefer de 1,3 mm de longueur et constitué d'un empilement de huit tôles de 0,35 mm d'épaisseur; sa section est de 10 mm$^2$ et sa longueur moyenne mesure 35 mm; et

La Fig. 7 est un graphique de la tension de sortie $V_{out}$ d'un capteur conventionnel, respectivement d'un capteur selon l'invention, en fonction des ampères-tours.

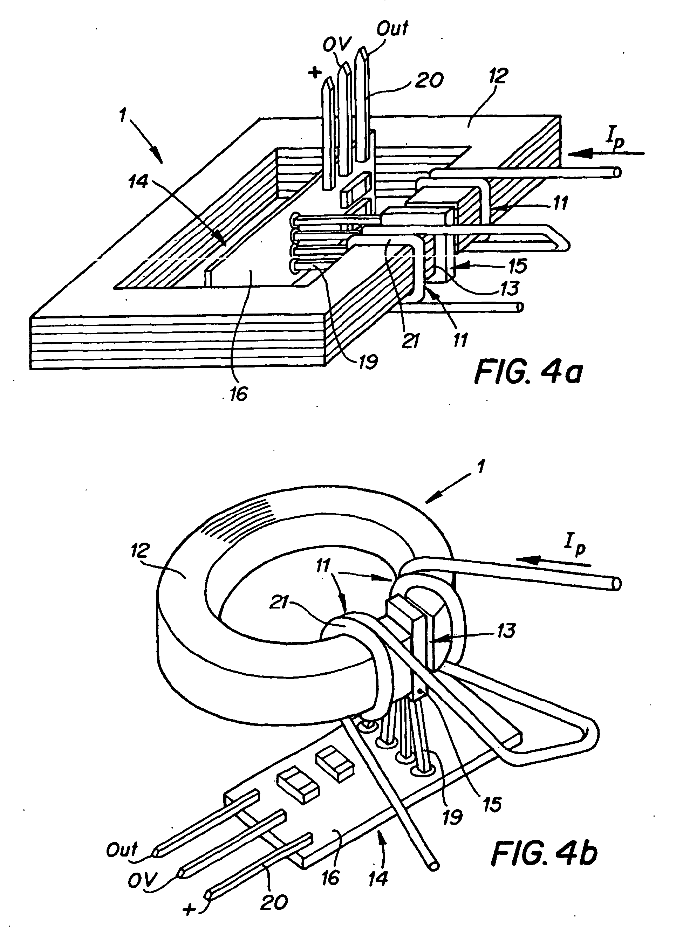

Dans les capteurs à boucle ouverte connus, quelque soit la forme du circuit magnétique, la bobine 110 (voir Fig. 3) constituant l'enroulement primaire Np est normalement placée sur un secteur, ou sur la branche 111 dans le cas d'un circuit magnétique rectangulaire 112, situé directement à l'opposé de l'entrefer 113, tel que montré dans la figure 3. Cet emplacement est effectivement celui qui apparaît le plus naturel; c'est aussi celui qui apparaît le plus logique du point de vue réalisation pratique, car le bobinage primaire peut être plus facilement enroulé autour de la branche opposé à l'entrefer en passant le fil par l'entrefer.

Cependant, les inventeurs ont réalisé que cet emplacement s'avère défavorable. En effet, si l'on porte attention aux phénomènes magnétiques qui découlent de cet arrangement, on constate que dans la portion de circuit magnétique 111 enserrée par la bobine primaire 110, le flux d'induction magnétique $\Phi$ est beaucoup plus élevé que dans le reste du circuit. Ceci est dû au fait que loin de l'entrefer 113, la perméabilité locale $\mu_r$, vue de l'endroit où sont placées les spires primaires, tend vers la valeur de celle du matériel magnétique employé, et on rappelle que $\Phi = B \times S$ et $B = \mu H$ donc $\Phi = \mu H \times s$, où B est l'induction magnétique, S est section de la bobine, H est le flux magnétique et $\mu$ la perméabilité. D'autre part, du fait de la présence de l'entrefer, une grande partie du flux d'induction magnétique généré par les ampères-tours primaires (flux principal $\Phi_p$) va se refermer en dehors du circuit magnétique (flux de dispersion $\Phi_d$). L'autre partie $\Phi_e$ se referme par le circuit magnétique et par l'entrefer 113 où s'effectue la mesure par un détecteur de champ magnétique 114, tel qu'une cellule de Hall.

Ainsi, on génère plus de flux inutile que de flux utile. Le flux inutile augmente considérablement les pertes dynamiques, les pertes par hystérésis et l'échauffement qui en résulte.

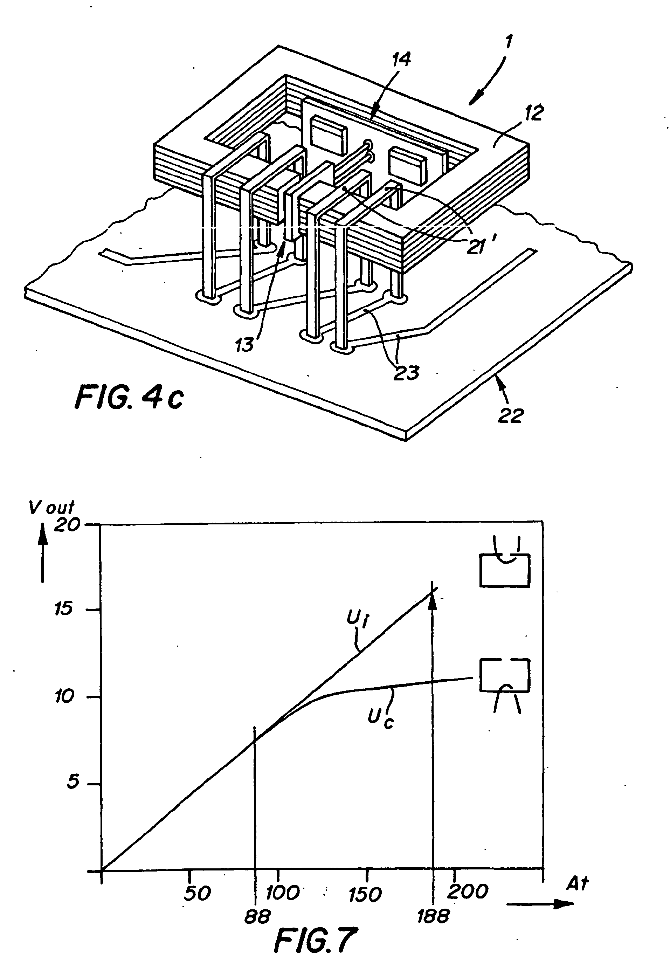

Faisant référence aux figures 4a à 4b, un capteur à boucle ouverte 1 selon l'invention comporte un circuit magnétique 12 comprenant un noyau magnétique ayant un entrefer 13, un élément de mesure de l'induction magnétique 14 comprenant une cellule de mesure de l'induction magnétique 15 disposé dans l'entrefer, et un conducteur primaire 11 ayant un ou plusieurs spires entourant le circuit magnétique. Le courant à mesurer $I_p$ (aussi appelé courant primaire) circule dans le conducteur primaire. La cellule de mesure peut par exemple être une sonde à effet Hall montée sur un circuit imprimé 16. de l'élément de mesure, le circuit comprenant des pistes conductrices reliant des bornes 19 de la cellule de mesure à des bornes 20 destinées à être connectées à un unité externe de traitement des signaux de mesure.

Les spires 21 du conducteur primaire 11 sont disposées autour du noyau magnétique 12 ,de préférence symétriquement, de part et d'autre et au plus près de l'entrefer 13. Les spires sont illustrées comme étant sous forme de spires d'un fil. Les spires peuvent toutefois prendre beaucoup d'autres formes. Par exemple (voir Fig. 4c), les spires peuvent être des conducteurs en forme de « U » 21', par exemple étampés de tôle métallique, entourant le circuit magnétique 12 et connectés par exemple à un circuit imprimé 22 muni de pistes conductrices 23 reliant les conducteurs en « U ». Il est à remarquer également que deux conducteurs en « U », un de chaque côté de l'entrefer, peuvent représenter un seule spire s'ils sont reliés électriquement en parallèle, par exemple par les pistes conductrices sur le circuit imprimé.

Dans la partie du circuit magnétique, proche de l'entrefer, la perméabilité locale est beaucoup plus faible que dans toutes les autres parties du circuit magnétique à cause de la présence de l'entrefer ($\mu_{air} = 1$). De ce fait, pour la même valeur d'ampères-tours primaires, l'induction magnétique dans le matériau du circuit magnétique est localement, mais aussi globalement, plus faible. Par conséquent, les pertes totales et l'échauffement qui en résulte sont aussi plus faibles. D'autre part, le flux de dispersion est aussi plus faible, car l'induction magnétique est plus faible. On tend ainsi à ne générer que du flux utile. Rappelons que, l'induction dans l'entrefer ne dépend pas de la position des spires primaires, comme il en ressort de l'explication ci-après:

Un capteur de courant à boucle ouverte est une application du théorème d'Ampère ($I = \int H \cdot dL$) qui peut s'écrire dans le cas pratique d'un circuit magnétique avec entrefer:

$$N_p \times I_p = H_{air} \times I_{air} + H_{fer} \times I_{fer}$$

$$\text{or } H = B / \mu \qquad \text{donc:}$$

$$N_p \times I_p = B_{air} \times I_{air} / \mu_o \times \mu_{air} + B_{fer} \times I_{fer} / \mu_o \times \mu_r$$

où $N_p$ est le nombre de spires primaires, $I_p$ est le courant primaire, $H_{air}$ est le champ magnétique circulant dans l'entrefer, $I_{air}$ est le longueur de l'entrefer, $H_{fer}$ est le champ magnétique circulant dans le noyau du circuit magnétique, $I_{fer}$ est la longueur du noyau magnétique, $B_{air}$ est l'induction magnétique dans l'entrefer, $B_{fer}$ est l'induction magnétique dans le noyau magnétique, $\mu_{air}$ est la perméabilité magnétique dans l'air, $\mu_r$, est la perméabilité magnétique dans le noyau magnétique et $\mu_o$ est une constante ayant la valeur $4 \pi 10^{-7}$.

Sachant que la perméabilité relative de l'air $\mu_{air}$ = 1, et partant de l'hypothèse simplificatrice que l'induction dans l'entrefer est égale à l'induction dans le fer, nous pouvons écrire:

$$N_p \times I_p \times \mu_o = B \times (I_{air} + I_{fer} / \mu_r)$$

et

$$N_p \times I_p \times \mu_o / I_{air} + I_{fer} / \mu_r = B_{air}$$

Or, dans notre cas, $I_{fer}$ est petit, tandis que $\mu_r$ est très grand (> 100.000), donc le rapport $I_{fer}/\mu_r$ est négligeable.

Finalement, la densité de flux magnétique mesuré par l'élément de Hall dans l'entrefer est:

$$B_{air} = 4 \pi 10^{-7} \times N_p \times I_p / I_{air}$$

Il faut rappeler toutefois qu'il est pratiquement impossible de calculer les valeurs d'induction et donc les pertes totales, dans le cas d'un circuit magnétique avec entrefer, car les résultats dépendent de la forme géométrique de l'ensemble magnétique. Seuls l'utilisation d'un logiciel approprié et/ou des essais permettent d'évaluer l'induction magnétique et l'échauffement.

Les Figures 6a et 6b sont des graphiques montrant l'évolution de la température dans le circuit magnétique d'un capteur conventionnel, respectivement d'un capteur selon l'invention sur une ligne alimentée par un courant sinusoïdal ayant une fréquence de 200 kHz. La Fig. 6a concerne un capteur avec: un circuit magnétique en fer-silicium ayant un entrefer de 1.3 mm de longueur et constitué d'un empilement de huit tôles de 0,35 mm d'épaisseur; sa section est de 9,8 mm$^2$ et sa longueur moyenne mesure 40 mm. La Fig. 6b concerne un capteur avec: un circuit magnétique en fer-nickel, ayant un entrefer de 1,3 mm de longueur et constitué d'un empilement de huit tôles de 0,35 mm d'épaisseur; sa section est de 10 mm$^2$ et sa longueur moyenne mesure 35 mm. Le capteur de la Fig. 6a comporte huit spires primaires parcourues par un courant de 5 A, soit 40 At. Le capteur de la Fig. 6b comporte douze spires primaires parcourues par un courant de 3,33 A, soit 40 At.

Dans le cas du circuit magnétique toroïdal selon la Fig. 4b, on constate sur la graphique de la figure 6a qu'après 12 minutes d'opération la température $T_c$ du circuit magnétique du capteur conventionnel atteint environ 136 °C (i.e. une augmentation d'environ 116 °C) alors que la température $T_i$ du circuit magnétique du capteur selon l'invention atteint environ 78 °C (i.e. une augmentation d'environ 58 °C). L'échauffement d'un capteur selon l'invention est donc environ 2 fois plus faible que dans un capteur conventionnel de mêmes forme et dimensions. Dans le cas du circuit magnétique rectangulaire selon la Fig. 4a, on constate sur la graphique de la figure 6b qu'après 12 minutes d'opération la température $T_c$ du circuit magnétique du capteur conventionnel atteint environ 116 °C (i.e. une augmentation d'environ 96 °C) alors que la température $T_i$ du circuit magnétique du capteur selon l'invention atteint environ 52 °C (i.e. une augmentation d'environ 32 °C). L'échauffement d'un capteur selon l'invention est donc environ 3 fois plus faible que dans un capteur conventionnel de mêmes forme et dimensions.

Un autre avantage résultant du capteur selon l'invention est que l'inductance d'insertion $L_{ins}$ du capteur est plus faible.

En effet :

$$L_{ins} = N^2/R_m \text{ et } R_m = I / \mu \times S$$

où N est le nombre de spires primaires, $R_m$ est la réluctance magnétique, S est la section effective de l'entrefer et I est la longueur de l'entrefer.

Or, dans le capteur selon l'invention, la perméabilité $\mu$ est plus faible et la section S aussi, car le flux est plus homogène du fait de la position de la bobine primaire à proximité de l'entrefer. A titre d'exemple, la Fig. 5 montre la tension U en fonction du temps pour une vitesse de variation de courant di/dt = 40.•10$^6$A/sec

$$U(t) = L_{ins} \frac{di}{dt}$$

obtenue avec un capteur conventionnel (courbe $U_o(t)$) et un capteur selon l'invention (courbe $U_i(t)$) de mêmes forme et dimensions, les deux ayant un seul spire primaire. On constate que pour le capteur conventionnel la tension crête $U_c$ est 810mV, ce qui donne par calcul une induction d'insertion $L_{ins}$ de 0.02 $\mu$H, alors que pour le capteur selon l'invention la tension crête $U_i$ est 460mV ce qui donne par calcul une induction d'insertion $L_{ins}$ de 0.0115 $\mu$H.

Un autre avantage est que la section du noyau magnétique nécessaire pour mesurer un courant donné est plus faible du fait que l'induction magnétique dans le noyau est plus faible, car les spires primaires enserrent une portion du circuit magnétique où la perméabilité apparente est faible.

La Fig. 7 montre qu'avec un capteur selon l'invention, constitué d'un circuit magnétique en fer-nickel avec environ 80% de nickel et de 3,36 mm$^2$ de section, la mesure de courant est linéaire jusqu'à 188 At, alors que dans un capteur conventionnel de mêmes forme, dimensions et qualité la mesure du courant n'est linéaire que jusqu'à 88 At.

Afin d'améliorer le capteur encore plus, on peut utiliser un matériel magnétique pour le noyau ayant des pertes faibles, comme par exemple les alliages fer-nickel qui ont des pertes jusqu'à trois fois plus faibles que celles des alliages Fer-silicium couramment utilisé dans ces applications. D'autre part on peut réduire l'épaisseur d des tôles magnétiques formant le noyau du circuit magnétique. L'épaisseur la plus courante dans les capteurs conventionnels est de 0,35mm. L'utilisation de tôles d'une épaisseur de 0,2mm peut apporter une diminution de pertes d'un facteur d'environ trois fois.

En résumé, le capteur à boucle ouverte selon l'invention exposée ci-dessus apporte de manière simple les avantages suivants:

- diminution importante des pertes dynamiques et des pertes par hystérésis
- diminution importante de l'inductance d'insertion des capteurs
- diminution importante de la section de fer pour la mesure d'un courant donné, donc diminution du coût en ce qui concerne la matière.

## Revendications

1. Capteur de courant à boucle ouverte (1), comprenant un circuit magnétique (12) ayant un noyau magnétique continu avec un seul entrefer (13), un détecteur de champ magnétique (14) disposé dans l'entrefer, et un conducteur primaire (11) ayant un ou plusieurs spires (24,25) entourant complètement le courant magnétique, le courant à mesure ($I_p$) circulant dans le conducteur primaire, le capteur étant **caractérisé en ce que** les spires. du conducteur primaire sont disposés à proximité de l'entrefer, de part et d'autre de l'entrefer.

2. Capteur selon la revendication 1, **caractérisé en ce que** les spires du conducteur primaire (11) sont disposées symétriquement de part et d'autre de l'entrefer.

3. Capteur selon la revendication 1 ou 2, **caractérisé en ce que** les spires du conducteur primaire (11) comprennent une partie en forme de "U" étampée et montée sur un circuit imprimé (22).

4. Capteur de courant selon l'une des revendications précédentes, **caractérisé en ce que** les spires du conducteur primaire (11) de part et d'autre de l'entrefer sont connectées en parallèle.

5. Circuit d'alimentation de puissance comprenant des commutateurs semi-conducteurs pour la génération d'un courant alternatif sinusoïdal fourni sur une ou plusieurs lignes d'alimentation d'une charge, telle qu'un moteur électrique, et un capteur de courant à boucle ouverte disposé sur chaque ligne, le capteur de courant ayant les caractéristiques de l'une quelconque des revendications précédentes.

## Patentansprüche

1. Open-loop-Stromwandler (1) mit einem magnetischen Kreis (12) mit durchgehendem Magnetkern und einem einzigen Luftspalt (13), einem im Luftspalt angeordneten Magnetfelddetektor (14) und einem Primärleiter (11) mit einer oder mehreren Windungen (21, 21'), die den magnetischen Kreis völlig umgeben, wobei der zu messende Strom (Ip) im Primärleiter fliesst und der Wandler **dadurch gekennzeichnet ist, dass** die Windungen des Primärleiters nahe dem Luftspalt zu beiden Seiten des Luftspalts angeordnet sind.

2. Wandler nach Anspruch 1, **dadurch gekennzeichnet, dass** die Windungen des Primärleiters (11) symmetrisch zu beiden Seiten des Luftspalts angeordnet sind.

3. Wandler nach Anspruch 1 oder 2, **dadurch gekennzeichnet, dass** die Windungen des Primärleiters (11) einen U-förmig ausgestanzten und auf eine gedruckte Schaltung (22) montierten Abschnitt umfassen.

4. Stromwandler nach einem der vorangehenden Ansprüche, **dadurch gekennzeichnet, dass** die Windungen des Primärleiters (11) zu beiden Seiten des Luftspalts parallel verbunden sind.

5. Leistungs-Stromversorgungsschaltung mit Halbleiterschaltern für die Erzeugung eines sinusförmigen Wechselstromes, der auf einer oder mehreren Versorgungsleitungen einer Last wie eines Elektromotors geliefert wird, sowie ein auf jeder Leitung angeordneter Open-loop-Stromwandler, der die Merkmale eines beliebigen der vorangehenden Ansprüche besitzt.

**Claims**

1. An open-loop current sensor (1) comprising a magnetic circuit (12) having a continuous magnetic core with a single air gap (13), a magnetic field detector (14) disposed in the air gap, and a primary conductor (21, 21') having one or more turns surrounding the magnetic circuit, the current to be measured $I_P$ flowing in the primary conductor, the sensor being **characterized in that** the turns of the primary conductor are disposed close to the air gap, on each side of the air gap.

2. A sensor according to Claim 1, wherein the turns of the primary conductor (11) are disposed symmetrically on each side of the air gap.

3. A sensor according to Claim 1, wherein the turns of the primary conductor (11) comprise a U-shaped part stamped and mounted on a printed circuit (22).

4. A current sensor according to claim 1, wherein the turns of the primary conductor (11) on each side of the air gap are connected in parallel.

5. A power supply circuit comprising semiconductor switches for generating a sinusoidal alternating current supplied on one or more supply lines of a load, such as an electric motor, and an open-loop current sensor disposed on each line, the current sensor having the characteristics of any one of the preceding claims.

**FIG. 1**

**FIG.2a**

FIG. 2b

FIG. 3

**FIG. 5**

**FIG. 2c**

FIG. 4a

FIG. 4b

FIG. 4 c

FIG. 7

FIG. 6a

FIG. 6b